# EUROPÄISCHE PATENTSCHRIFT

(11) **EP 2 229 431 B1**
(45) Veröffentlichungstag und Bekanntmachung des Hinweises auf die Patenterteilung: **20.02.2013**
(21) Anmeldenummer: 08856592.4
(22) Anmeldetag: 08.12.2008
(51) Int. Cl.: C11D 7/06, C11D 7/26, C11D 7/32, C11D 11/00

(54) **TEXTUR- UND REINIGUNGSMEDIUM ZUR OBERFLÄCHENBEHANDLUNG VON WAFERN UND DESSEN VERWENDUNG**
TEXTURING AND CLEANING MEDIUM FOR THE SURFACE TREATMENT OF WAFERS AND USE THEREOF
PRODUIT DE NETTOYAGE ET DE TEXTURATION POUR LE TRAITEMENT DE SURFACE DE PLAQUETTES ET SON UTILISATION

(30) Priorität: 06.12.2007 DE 102007058829
(43) Veröffentlichungstag der Anmeldung: 22.09.2010
(73) Patentinhaber: Fraunhofer-Gesellschaft zur Förderung der angewandten Forschung e.V., 80686 München (DE)
(72) Erfinder: MAYER, Kuno, 79114 Freiburg (DE); SCHUMANN, Mark, 79102 Freiburg (DE); KRAY, Daniel, 79098 Freiburg (DE); ORELLANA PERES, Teresa, 79102 Freiburg (DE); RENTSCH, Jochen, 79312 Emmendingen (DE); ZIMMER, Martin, 79117 Freiburg (DE); KIRCHGÄSSNER, Elias, 79117 Freiburg (DE); ZIMMER, Eva, 79117 Freiburg (DE); BIRO, Daniel, 79106 Freiburg (DE); ROSTAS, Arpad, Mihai, 79102 Freiburg (DE)
(74) Vertreter: Pfenning, Meinig & Partner GbR
(86) Internationale Anmeldenummer: PCT/EP2008/010402
(87) Internationale Veröffentlichungsnummer: WO 2009/071333

(56) Entgegenhaltungen:
- EP-A- 1 284 306
- WO-A-98/45399
- WO-A-02/065538
- WO-A-2005/031837
- US-A1- 2001 018 407
- US-A1- 2005 181 961
- US-A1- 2006 166 847
- US-B1- 6 399 552
- US-B1- 6 514 921
- US-B1- 6 546 939

## Beschreibung

Die Erfindung betrifft ein flüssiges Medium für die Oberflächenbehandlung von monokristallinen Wafern, das ein alkalisches Ätzmittel sowie mindestens eine schwer flüchtige organische Verbindung enthält. Derartige Systeme können sowohl für die Reinigung, Schadensätze und Texturierung von Waferoberflächen in einem einzigen Ätzschritt als auch ausschließlich für die Texturierung von Silizium-Wafern mit unterschiedlicher Oberflächenqualität, seien es nun drahtgesägte Wafer mit starker Oberflächenschädigung oder chemisch polierte Oberflächen mit minimaler Schädigungsdichte, eingesetzt werden.

Bei bisherigen Produktionsverfahren werden die Waferreinigung von den Slurryresten nach dem Drahtsägen und die Wafertextur in zwei unterschiedlichen Prozessketten vollzogen. Beide Prozesse werden arbeitsteilig von Waferherstellern und Solarzellenproduzenten durchgeführt. Die Slurry-Waferreinigung erfolgt unmittelbar nach dem Drahtsägen bei den Waferherstellern. Sie umfasst im Wesentlichen eine Beseitigung der durch das Drahtsägen auf die Waferoberfläche aufgebrachten Kontaminationen. Dazu zählt vor allem der Abrieb an Silizium, sowie der Bestandteile des Drahtes und der verwendeten Schleif- und Haftmittel (Slurry). Die gereinigten Wafer verfügen nach Verlassen der Reinigungsanlage über eine mehr oder weniger intensive kristalline Schädigung der Oberfläche, die in einem weiteren Prozessschritt abgetragen werden muss.

Die Textur der Waferoberfläche fällt, sofern sie überhaupt durchgeführt wird, in den Aufgabenbereich der Solarzellenhersteller. Ihr voraus geht bei der Herstellung hocheffizienter Solarzellen ein aufwändiger dreiteiliger Nachreinigungsschritt, der an die Wafernachreinigung in der Chip-Industrie angelehnt ist. Diese RCA-Reinigung (D. C. Burkman, D. Deal, D. C. Grant, C. A. Peterson: "Aqueous Cleaning Processes in Handbook of Semiconductor Wafer Cleaning Technology, Science", Technology and Applications, East Windsor, N. J., USA (1993) S. 111-129) umfasst:
1.) Oxidätzen mit HF/HNO₃;
2.) SC-1-Reinigung mit H₂O/NH₄OH/H₂O₂ mit anschließendem HF-Dip.;
3.) SC-2-Reinigung mit (H₂O/HCl/H₂O₂), der die durch den Transport auf die Waferoberfläche aufgebrachte Kontamination sowie verbliebene metallische und organische Verunreinigungen nach der Vorreinigung durch die Waferhersteller beseitigt (Fig. la).

Nach jeder chemischen Behandlung durchwandern die Wafer noch einen Spülschritt mit hochreinem, deionisiertem Wasser, bevor sie in die nächste Ätzlösung gelangen. Auf diese Weise ist allein für die RCA-Reinigung eine Gesamtanzahl an Becken von ca. 8 die Regel (O. Doll: "Komplexbildner für alkalische Reinigungslösungen von Halbleitersilicium-Oberflächen: Aspekte ihrer Wirksamkeit und ihrer chemischen Stabilität", PhD-Thesis, Frankfurt/Main (2005)) mit geringen Abweichungen bei den verschiedenen Herstellern.

Bei kommerziellen Solarzellen wandern die von den Waferherstellern, von der Slurry gereinigten Wafer direkt in den Texturprozess, der bei der basischen Textur nach dem bisherigen Stand der Produktion kommerzieller Solarzellen im industriellen Maßstab in einer Batch-Anlage durchgeführt wird und gleichzeitig auch als Schadensätze dient. Es ist aber auch möglich, dass die Schadensätze als separater Prozessschritt vor der Textur durchgeführt wird. Nach Aufbringen der Textur werden die Wafer einem jeweils bis zu einminütigen HCl- und HF-Dip unterzogen, bevor die Emitterdiffusion durchgeführt wird (Fig. 1b). Der HCl-Dip soll die auf den Waferoberflächen verbliebenen Reste an KOH-Lösung neutralisieren und deren weiteren chemischen Angriff auf die Waferoberfläche stoppen. Ebenso sollen die durch die alkalische Ätzlösung zusätzlich auf der Siliziumoberfläche deponierten metallischen Verunreinigungen, vor allem die aus der basischen Lösung gefällten, schwerlöslichen Hydroxide der dreiwertigen Metall-Ionen Fe³⁺ und Al³⁺ wieder in Lösung gebracht werden. Der HF-Dip einen Abtrag des nach dem Texturschritt auf den Wafern vorhandenen, nativen Oxids gewährleisten soll.

Die Waferreinigung wird bisher auf zwei Verfahrenswegen vollzogen: entweder in einem Batch- oder in einem Inline-Prozess, wobei jeweils zwei Anlagen, eine für die Slurry-Reinigung und eine für die Textur, zum Einsatz kommen. Für die Wafertextur ist bisher ein Batch-Prozess technischer Standard. Dabei werden für Reinigung und Textur auch unterschiedliche Chemikaliensysteme eingesetzt: Reinigungstenside enthaltende, nur schwach basische Medien (pH 8-9) für die Reinigung, und Texturtenside enthaltende, stark basische Medien (pH > 13) für die Textur. Reinigungstenside und Texturtenside sind bei der bisherigen Solarzellen-Prozessierung nicht identisch. In beiden Fällen wird der pH der Medien über Zugabe von Alkalihydroxiden (in der Regel NaOH bei der Reinigung und KOH bei der Textur) reguliert.

Beim Batch-Reinigungsprozess durchwandern die kontaminierten Wafer in definierten Portionen Chemikalienbecken unterschiedlicher Komposition. Als Reinigungsmedien dienen in aller Regel wässrige alkalische Medien auf der Basis von Kalium- oder Natriumhydroxid mit verschiedenen tensidischen Zusätzen. Chemikalien- und Reinstwasserkaskaden nutzen als wesentliches physikalisches Prinzip bei der Reinigung den Verdünnungseffekt, der sich beim Durchwandern der Wafer durch eine Vielzahl von Becken ergibt. Die Prozesszeit für eine Charge, all jene Teilschritte von der Wafervereinzelung nach dem Drahtsägen bis zum fertig gereinigten Wafer umfassend, beträgt hier in aller Regel mehr als eine Stunde.

Einen strafferen zeitlichen Ablauf gewährleistet die Inline-Reinigung, bei der die Wafer fließbandartig über ein Rollenfeld befördert werden, wobei sie in den verschiedenen, nicht streng voneinander abgegrenzten Abschnitten der Reinigungsbank variablen chemischen und physikalischen Bedingungen ausgesetzt sind. Die Inline-Reinigung ist anders als die Batch-Reinigung ein kontinuierlicher Prozess. Sie ermöglicht einen kontinuierlichen Austausch der Reinigungsmedien parallel zur Reinigung ohne Unterbrechung des Prozesses und eine verbesserte Medienkontrolle. Aus chemischer Sicht kommen hier ähnliche Reinigungsmedien zum Einsatz wie bei der Batch-Reinigung.

Zur Texturierung der Oberfläche monokristalliner Siliziumwafer wird bei der Solarzellenherstellung zumeist ein alkalisches Medium bestehend aus Kaliumhydroxid und 2-Propanol verwendet. Zur Wahrung eines ausreichenden Ätzabtrages zur Sägeschadenentfernung sind Ätzzeiten im Bereich zwischen 15 und 25 Minuten üblich, weswegen ausschließlich Produktionsanlagen im Batchverfahren eingesetzt werden. Bei der Texturierung wird die Anisotropie alkalischer Ätzmedien im Ätzverhalten unterschiedlicher Kristallrichtungen im Silizium ausgenutzt um so genannte "zufällig verteilten Pyramiden", englisch "Random Pyramids" zu erzeugen. Als weitere alkalische Ätzmittel neben KOH sind des Weiteren Natriumhydroxid, Tetramethyl-Ammoniumhydroxid und Ethylendiamin Pyrocatechol genannt, wobei sich die hier genannten, organischen Ätzmittel vor allem in einer längeren Bearbeitungszeit von den beiden anorganischen unterscheiden, dafür aber im Gegenzug keine metallischen Kationen aufweisen. Kaliumhydroxid wird bei den anorganischen Ätzmedien gegenüber Natriumhydroxid bevorzugt, weil die nach der Textur auf der Oberfläche verbliebenen Natrium-Ionen aufgrund ihrer höheren Diffusionsgeschwindigkeit gegenüber den größeren Kalium-Ionen als mobile Ladungsträger im Oberflächenoxid der Silizium-Wafer wirken können. Dies wirkt sich negativ auf die elektrischen Eigenschaften vor allem oxidpassivierter Silizium-Substrate aus.

Die US 2006/0166847 A1 offenbart Zusammensetzungen und Verfahren für die Prozessierung von Halbleitersubstraten, wobei die Zusammensetzung ein quaternäres Ammoniumhydroxid, ein Alkanolamin, und einen Komplexbilnder enthält. In der US 2005/0181961 werden Reinigungszusammensetzungen offenbart, welche nach dem chemisch mechanischen Polieren (CMP) von metallhaltigen Halbleitersubstraten verwendet werden, wobei die Zusammensetzungen Ammoniumhydroxid oder Tetraalkylammoniumhydroxid, einen Komplexbildner und einen Korrosionsinhibitor enthalten. Die WO 02/065538 offenbart eine wässrige Reinigungslösung zur Reinigung von kupferhaltigen Mikroelektroniksubstraten, welches Tetraalkylammoniumhydroxid, ein polares organisches Amin, einen Korrosionsinhibitor und Gallussäure enthält. In der US 6,399,552 B1 wird eine Reinigungslösung für integrierte Schaltkreise offenbart, welche Ammonium- oder Kaliumhydroxid, ein Fluoridreduktionsmittel und Essigsäure oder Citronensäure enthält. In der US 6,546,939 B1 wird ein Verfahren zur Reinigung einer metallischen oder dielektrischen Oberfläche offenbart, in welchem die Oberfläche mit einer wässrigen Zusammensetzung kontaktiert wird, die einen pH von 3,5-7, eine mono-, di- oder trifunktionelle organische Säure, Cholinhydroxid und eine Komponente ausgewählt aus quaternäres Amin, Ammoniumhydroxid, Hydroxylamin(-salz), Hydrazin(-basissalz) enthält. Die WO 98/45399 lehrt eine Zusammensetzung um Fotolack oder polymeres Material von Substraten zu entfernen, wobei die Zusammensetzung entweder EDTA oder ein Mono-, Di-, Tri- oder Tetraammoniumsalz und Wasser oder ein polares organisches Lösungsmittel enthält. In der US 6,514,921 B1 wird ein Reinigungsmittel für Halbleitersubstrate offenbart, welches hochreines Wasser, eine organische Säure mit 1-3 Carboxylgruppen, ein Komplexierungsmittel wie z.B. EDTA und ein Tensid enthält. Die US 2001/0018407 offenbart ein Reinigungsmittel für Halbleitersubstrate enthaltend eine organische Säure mit wenigstens einer Carboxylgruppe und einen Komplexbildner mit Komplexbildungsfähigkeit. In der EP 1 284 306 A2 wird eine Silanzusammensetzung offenbart enthaltend eine Polysilanverbindung und zumindest eine Silanverbindung ausgewählt aus Cyclopentasilan, Cyclohexasilan und Silylcyclopentasilan. Die WO 2005/031837 offenbart ein Mittel zum Ätzen von Silizium, welches Kaliumhydroxid und/oder Ammoniumhydroxid, ein wasserlösliches, nichtflüchtiges und nicht entflammbares Additiv und ein wässriges Lösungsmittel enthält.

Ausgehend hiervon war es Aufgabe der vorliegenden Erfindung, ein wässriges Chemikaliensystem bereitzustellen, das eine einfachere Prozessierung (Reinigung, Schadensätze und Textur) bei der Solarzellenherstellung erlaubt. Dies umfasst ebenso die damit verbundene apparative Vereinfachung und Kostenreduktion im Herstellungsprozess.

Diese Aufgabe wird durch das flüssige Textur- und Reinigungsmedium mit den Merkmalen des Anspruchs 1 gelöst. Die weiteren abhängigen Ansprüche zeigen vorteilhafte Weiterbildungen auf. In Anspruch 13 wird eine erfindungsgemäße Verwendung aufgeführt.

Üblicherweise bestehen Texturlösungen aus einem Hydroxid-Ionen-Lieferanten (OH⁻-Ionen), bei dem es sich um eine organische oder anorganische Base handelt und einem oberflächenaktiven Stoff, einem sogenannten Tensid, das beim Solarzellenherstellungsprozess üblicherweise ein organisches Lösungsmittel, vorwiegend 2-Propanol, ist.

Der chemische Angriff auf das Silizium in einem basischen wässrigen Milieu, hier am Beispiel von Kaliumhydroxid-Lösung gezeigt, folgt der Reaktionsgleichung:

2 K⁺(aq) + 2 OH⁻(aq) + 2 H₂O(l) + Si(s)

2 K⁺(aq) + Si(OH)₂O₂²⁻ (aq) + 2 H₂ (g)

Als Reaktionsprodukte entstehen wasserlösliche Salze der Kieselsäure, hier: Kaliumsilicat und elementarer Wasserstoff, der nach Überschreiten der Sättigungsgrenze in der Lösung aus dieser als Gas entweicht.

Das Tensid verfügt über mindestens eine hydrophile und mindestens eine hydrophobe Gruppe. Beim reinen Texturprozess besitzt es zwei wesentliche Aufgaben:
1. Durch seinen Doppelcharakter als wasserlöslicher hydrophiler und hydrophober Stoff ist es in der Lage, sowohl hydrophile wie hydrophobe Silizium-substrate vollständig zu benetzen. Wird die Siliziumoberfläche beispielsweise vor dem Texturschritt einer Politurätze mit Flusssäure enthaltenden Medien unterzogen, so ist die Oberfläche mit Wasserstoffatomen terminiert, d.h. jene Valenzen der Oberflächenatome, an die keine weiteren Silizium-Atome mehr anschließen, sind mit Wasserstoff abgesättigt. Aufgrund der geringen Elektronegativitätsdifferenz zwischen Silizium und Wasserstoff sind diese Bindungen unpolar; eine solche Oberfläche ist entsprechend hydrophob. Verfügt die Oberfläche hingegen über eine dünne Schicht nativen Oxids, wie es sich beispielsweise bei frisch gesägten Wafern ausbildet, während diese beim Drahtsägeprozess feuchter Slurry ausgesetzt sind, so ist die Oberfläche vorwiegend hydrophil, aufgrund der starken Polarität der Si-O-Bindung, die von der hohen Elektronegativitätsdifferenz zwischen Silizium und Sauerstoff herrührt.
   Eine vollständige und gleichmäßige Benetzung der Oberfläche ist für die Ausbildung einer gleichmäßigen Textur des Siliziumsubstrats unverzichtbar. Ist eine uniforme Benetzung der Oberfläche nicht gegeben, so sind unterschiedliche Regionen der Substratoberfläche unterschiedlich stark dem chemischen Angriff des Ätzmediums ausgesetzt, was die Ausbildung von Ätzpyramiden stark variierender Größe zur Folge hat. Neben einem höheren Reflexionsgrad haben diese Oberflächen noch den Nachteil einer schwierigeren Prozessierbarkeit und sind daher im Solarzellenfertigungsprozess unerwünscht.
2. Organische Flüssigkeiten verfügen in der Regel über eine um ein Vielfaches höhere Löslichkeit unpolarer Gasmoleküle als das polare Lösungsmittel Wasser. Dies hat wiederum zur Folge, dass auch der sich beim Ätzvorgang mit Hydroxid-Ionen bildende Wasserstoff in dem absorbierten Oberflächenfilm aus organischem Lösungsmittel besser gelöst und somit länger an der Oberfläche festgehalten wird als in rein wässriger Lösung. Das Ergebnis ist eine starke Bedeckung der Siliziumoberfläche mit feinsten Gasbläschen, die als Keime für die Ausbildung von Texturpyramiden fungieren.

Eine Theorie zur Oberflächentexturierung von Silizium-Substraten besagt, dass feinste, an der Oberfläche adsorbierte Gasbläschen lokal und temporär den Ätzangriff von Hydroxid-Ionen auf das Substrat blockieren. An den Stellen wo Gasbläschen haften, tritt der Angriff demnach retardiert ein, während die Umgebung um die Gasbläschen herum bereits abgetragen wird. Die blockierten Stellen bilden später die Spitzen der sich ausbildenden Ätzpyramiden. Obwohl diese Theorie zum Hergang des Ätzvorgangs nicht einhellig vertreten wird, herrscht doch weitestgehende Einigkeit in der Literatur über die Notwendigkeit einer starken und gleichmäßigen Absorption des gebildeten Wasserstoffs an der Substrat-Oberfläche als Voraussetzung für die Ausbildung einer qualitativ hochwertigen Textur.

Als hydrophobe Gruppen dienen in Tensiden beispielsweise verschiedene Alkyl-Gruppen, Vinyl-Gruppen oder aromatische Systeme, z.B. Phenyl-Reste. Auch Kombinationen dieser Gruppen sind möglich, wie etwa bei der Toluolsulfonsäure, welche über einen Benzol-Ring mit einer Methyl-Seitenkette verfügt.

Hydrophile Gruppen sind beispielsweise Hydroxy-Gruppen (-OH), wie im Falle des klassischen Texturmittels Isopropanol, SO₃H-Gruppen, wie bei der Toluolsulfonsäure, Nitro-Gruppen (-NO₂) Carboxyl-Gruppen (-COOH), Phosphat-Reste (-O-PO₃H) oder Ammonium-Reste (-NH₄⁺), um nur einige Möglichkeiten zu nennen.

Art und Länge der hydrophoben und hydrophilen Reste bestimmen die Benetzungs- und Gaslöseeigenschaften der Tenside, ebenso wie ihren Siedepunkt.

Je länger beispielsweise der hydrophobe Rest des Tensids ist, desto stärker sind die van der Waals-Kräfte, die zwischen den Molekülen des Tensids wirken und desto höher ist sein Siedepunkt. Das Isopropanol, das nur über zwei kurzkettige (Methyl-)Gruppen verfügt besitzt daher einen relativ niedrigen Siedepunkt von 82°C, während p-Toluolsulfonsäure mit seinem längeren hydrophoben Rest erst bei 140 °C siedet.

Je höher der unpolare, hydrophobe Anteil in den Tensid-Molekülen, desto höher ist auch seine Lösungskapazität für unpolare (Wasserstoff-)Gasmoleküle.

Neben einer gleichmäßigen Benetzung der Oberfläche des zu texturierenden Wafers und ihrer Unterstützung bei der Gasabsorption an der Wafer-Oberfläche leisten Tenside noch einen weiteren wichtigen Beitrag bei der Prozessierung der Solarzellenwafer: Sie fungieren als effektive Reinigungsmittel für die Wafer, indem sie organische Verunreinigungen, etwa Schwebeteilchen oder organische Reste, aus der Slurry, wie etwa Polyethylenglykol, Epoxid-Harze, oder Klebstoffreste in der wässrigen Lösung binden und dadurch deren Deposition auf der Substratoberfläche verhindern.

Anorganische, metallische Verunreinigungen können ebenfalls durch einige organische Reagenzien, die hier als Texturmittel eingesetzt werden, sehr effektiv gebunden werden.

Die Isolation der organischen Kontaminationen in Lösung erfolgt über Micellenbildung. Micellen sind kugelförmige Agglomerate aus Tensidmolekülen, in deren Zentrum sich die meist unpolare organische Verunreinigung befindet, umgeben von den unpolaren Resten der Tensid-Moleküle. Die polaren Reste der Tensid-Moleküle, welche die Oberfläche der Micelle bilden, sorgen für die Löslichkeit der Micelle im polaren Lösemittel Wasser.

Die Fähigkeit zur Micellen-Bildung ist nicht bei allen oberflächenaktiven Stoffen gleichermaßen ausgeprägt. Sie ist unter anderem von der Beschaffenheit des hydrophoben Restes abhängig, allem voran seiner räumlichen Ausdehnung. Aus diesem Grund ist beispielsweise Isopropanol mit seinen zwei sehr kurzen hydrophoben Resten ein sehr schlechter Micellenbildner, während langkettige Carbonsäuren oder deren Anionen, die klassischen Bestandteile vieler Reinigungsmittel, sehr gute Micellenbildner sind.

Mit steigender Kettenlänge des hydrophoben Rests sinkt die Wasserlöslichkeit des Tensids. Langkettige Carbonsäuren (mit Kettenlängen von mehr als 6 C-Atomen) sind daher zunehmend schlechter wasserlöslich. Sie sind zwar gute Micellenbildner, aber schlechte Texturmittel, letzteres unter anderem auch deswegen, weil sie häufig nicht mehr in der Lage sind, die Siliziumoberfläche vollständig und gleichmäßig zu benetzen. Gründe hierfür sind zum einen ihre geringe Adhäsion an hydrophilen Bereichen der Substratoberfläche relativ zu ihrer Molekülgröße ebenso wie die stark abnehmende Löslichkeit im polaren Medium Wasser, wodurch die Konzentration an gelösten Tensidmolekülen hin zu größeren hydrophoben Kettenlängen so gering wird, dass sie für eine vollständige Bedeckung der Substratoberfläche nicht mehr ausreicht. Hinsichtlich der Benetzungseigenschaften wirken lang- und kurzkettige Tenside, ionische und nichtionische komplementär. Aus diesem Grund stellt es sich als sinnvoll dar, beim Erzielen möglichst hoher und homogener Substratbedeckungen unterschiedliche Arten von Tensiden parallel einzusetzen.

Das Mischungsverhältnis zwischen Tensiden mit langkettigen und kurzkettigen hydrophoben Resten, ebenso wie das Mischungsverhältnis zwischen ionischen und nicht-ionischen Tensiden bestimmt das Pyramidenwachstum und somit auch die Texturqualität.

Toluolsulfonsäure beispielsweise stellt hingegen hierbei einen guten Kompromiss zwischen Texturwirksamkeit und Reinigungswirkung dar. Anders als die langkettigen Carbonsäuren ist sie in hoher Konzentration in Wasser löslich und daher in einem weiten Konzentrationsbereich einsetzbar. Gleiches gilt für einige kurzkettige (Hydroxy-)Carbonsäuren und -Dicarbonsäuren mit und ohne Zusätze einer leichter flüchtigen organischen Komponente, etwa eines kurzkettigen Alkohols.

Aromatische Alkohole, wie beispielsweise Brenzcatechin (1,2-Dihydroxybenzol), einige Diarbonsäuren, z.B. Oxalsäure und Hydroxycarbonsäuren, z.B. Weinsäure, ebenso wie zahlreiche Aminocarbonsäuren, wie beispielsweise EDTA (Ethylendiamintetraessigsäure, TITRIPLEX III) und CDTA (trans-1,2-Cyclohexandiamin-tetraessigsäure, TITRIPLEX IV), DTPA (Diethylendiamin-pentaessigsäure, TITRIPLEX V), sind außerdem in der Lage, mit einigen Metall-Ionen in basischer wässriger Lösung Chelat-Komplexe zu bilden, die dazu beitragen, dass diese Metall-Ionen nicht mehr an der Waferoberfläche absorbiert oder als schwerlösliche Salze deponiert werden, sondern in Lösung verbleiben.

Weinsäure bildet beispielsweise mit den Metall-Ionen Fe³⁺, Al³⁺, Cr³⁺, Pb²⁺, Cu²⁺ sehr stabile Chelat-Komplexe und erhöht dadurch deren Löslichkeit in basischen Lösungen, aus denen diese in Abwesenheit des Chelatbildners als schwer lösliche Hydroxide ausfallen.

Die reinigende Wirkung dieser organischen Verbindungen sowohl auf die Lösung als auch Silizium-SubstratOberflächen ist in der Halbleitertechnik bekannt.

Toluolsulfonsäure ist tensidischer Hauptbestandteil des Wafer-Reinigungsmittels PURATRON® 67 der Firma ICB GmbH & Co. KG. Alkyl-Sulfonsäuren im Allgemeinen sowie deren alkyl- und (poly-)alkoxyl-substituierte Derivate sind als Reinigungstenside und nicht als texturwirksame Stoffe bekannt.

Erfindungsgemäß wird ebenso ein Texturmedium für die Oberflächenbehandlung von monokristallinen Wafern bereitgestellt. Dieses Texturmedium enthält mindestens ein alkalisches Ätzmittel für monokristallines Silicium und mindestens eine schwerflüchtige organische Verbindung mit einer Siedetemperatur von mehr als 110°C, bevorzugt mehr als 120 °C und besonders bevorzugt mehr als 150°C.

Das erfindungsgemäße Texturmittel besitzt den Vorteil, dass hier tendenziell höhere Prozesstemperaturen genutzt werden können, z.B. Temperaturen oberhalb von 110°C, im Vergleich zu jenen Verfahren, bei denen ausschließlich flüchtige Texturmittel zum Einsatz kommen, da hier Temperaturen von ca. 80°C, dem etwaigen Siedepunkt von Isopropanol (82°C) und Ethanol (78 °C) gängig sind. Höhere Prozesstemperaturen gewährleisten dabei einen schnelleren Ätzangriff des Reinigungs- und Texturmediums ohne die Gefahr eines schnellen Ausgasens der Komponenten und verringern dadurch die Prozesszeiten. Andererseits fördern hohe Prozesstemperaturen aber auch die unerwünschte Diffusion einiger metallischer Verunreinigungen aus der Lösung in das Silizium-Substrat, wenn diese nicht bereits in der Lösung gebunden werden, z.B. durch Komplexbildung. Weiterhin sind einige der schwerflüchtigen Texturmittel kostengünstig in der Anschaffung und gleichzeitig biologisch abbaubar, da es sich bei vielen dieser Verbindungen um Naturstoffe handelt, was ebenfalls die Prozesskosten reduziert.

Bevorzugt weist die schwerflüchtige organische Verbindung eine Siedetemperatur von ≥ 120°C, besonders bevorzugt ≥ 150°C auf.

Wichtig sind im Textur- und Reinigungsmittel als schwerflüchtige organische Verbindung gesättigte oder ungesättigte alphatische (Poly)alkohole, ausgewählt aus der Gruppe bestehend aus geradkettigen, verzweigten oder cyclischen C₄-C₈-Diolen oder C₆-C₁₂-Triolen oder Mischungen hiervon. Besonders bevorzugt sind 1,5-Pentandiol, 1,6-Hexandiol, cis/trans-1,X-Cyclopentandiol (X=2,3), cis/trans-1,X-Cyclohexandiol (X=2,3,4), cis/trans-1,X-Cycloheptandiol (X=2,3,4), Cyclohexantriole, Cycloheptantriole, Cyclononantriole, insbesondere 1,4,7-Cyclononantriol, cis/trans-1,4-Cyclohexandiol und Mischungen hiervon.

Als besonders bevorzugter Vertreter aus der Reihe der schwerflüchtigen Alkohole sei das cis/trans-1,4-Cyclohexandiol hervorgehoben. Aufgrund seiner extrem schnellen Texturwirkung auf Silizium-Substrate, wird eine Inline-Texturierung überhaupt erst ermöglicht, welche mit dem bisherigen Standard-Texturmittel 2-Propanol nicht möglich ist, insbesondere aufgrund der hohen Flüchtigkeit des 2-Propanol und der daraus resultierenden Instabilität der Badzusammensetzung.

Die Reinigungswirkung der (Poly)alkohole basiert zum einen darauf, dass Polyalkohole gute Lösemittel für organische Verunreinigungen sind. Zum anderen können Hydroxy-Gruppen in cis-Stellung zueinander Metallionen als -Liganden komplexieren und auf diese Weise deren Re-depostion auf der Waferoberfläche verhindern. Die Metall-Sauerstoff-Bindung wird bei (Poly)alkoholen im Gegensatz zu einfachen Alkoholen zusätzlich durch einen Intropieeffekt stabilisiert.

Die mindestens eine schwerflüchtige organische Verbindung wird dabei vorzugsweise in einer Konzentration von 1 bis 20 Gew.-%, besonders bevorzugt 2 bis 10 Gew.-%, jeweils bezogen auf das gesamte Texturmedium, eingesetzt.

Eine weitere Variante sieht vor, dass als schwerflüchtige organische Verbindungen solche aus der Gruppe der aromatischen Sulfonsäuren oder aromatischen (Poly-)Alkohole, z.B. Resorcin oder Brenzcatechin, oder aromatischen Ether eingesetzt werden, die gegebenenfalls entweder durch unpolare Seitenketten, etwa ein oder mehrere Alkyl- (z.B. Ethyl-, Propyl-, Oktyl, Isopropyl-, ter-Butyl, etc.), Alkylenoxid- (z.B. Ethylenoxid- oder Polyethylenglykoloxid-), Alkylvinyl-Gruppen, oder durch polare Seitenketten, etwa Hydroxy-Gruppen, -SO₃H-Gruppen, Carboxyl-Gruppen, -SH-Gruppen, Amino-Gruppen, substituiert sein können. Besonders bevorzugt aus der Gruppe der aromatischen Sulfonsäuren mit einer Alkyl-Seitenkette ist Toluolsulfonsäure, während ein bevorzugter Vertreter welche mit dem bisherigen Standard-Texturmittel 2-Propanol nicht möglich ist, insbesondere aufgrund der hohen Flüchtigkeit des 2-Propanol und der daraus resultierenden Instabilität der Badzusammensetzung.

Die Reinigungswirkung der (Poly)alkohole basiert zum einen darauf, dass Polyalkohole gute Lösemittel für organische Verunreinigungen sind. Zum anderen können Hydroxy-Gruppen in cis-Stellung zueinander Metallionen als -Liganden komplexieren und auf diese Weise deren Re-depostion auf der Waferoberfläche verhindern. Die Metall-Sauerstoff-Bindung wird bei (Poly)alkoholen im Gegensatz zu einfachen Alkoholen zusätzlich durch einen Intropieeffekt stabilisiert.

Die mindestens eine schwerflüchtige organische Verbindung wird dabei vorzugsweise in einer Konzentration von 1 bis 20 Gew.-%, besonders bevorzugt 2 bis 10 Gew.-%, jeweils bezogen auf das gesamte Texturmedium, eingesetzt.

Eine weitere Variante sieht vor, dass als schwerflüchtige organische Verbindungen solche aus der Gruppe der aromatischen Sulfonsäuren oder aromatischen (Poly-)Alkohole, z.B. Resorcin oder Brenzcatechin, oder aromatischen Ether eingesetzt werden, die gegebenenfalls entweder durch unpolare Seitenketten, etwa ein oder mehrere Alkyl- (z.B. Ethyl-, Propyl-, Oktyl, Isopropyl-, ter-Butyl, etc.), Alkylenoxid- (z.B. Ethylenoxid- oder Polyethylenglykoloxid-), Alkylvinyl-Gruppen, oder durch polare Seitenketten, etwa Hydroxy-Gruppen, -SO₃H-Gruppen, Carboxyl-Gruppen, -SH-Gruppen, Amino-Gruppen, substituiert sein können. Besonders bevorzugt aus der Gruppe der aromatischen Sulfonsäuren mit einer Alkyl-Seitenkette ist Toluolsulfonsäure, während ein bevorzugter Vertreter aus der Gruppe der alkoxyl-substituierten aromatischen Alkohole 1,3-Dihydroxy-4-Ethoxy-Benzol ist. Als bevorzugte Vertreter aus der Reihe der aromatischen, alkylsubstituierten (Poly-)Ether seien hier Triton X-100® (Polyethylenglykol-tert-oktylphenylether), Tergitol NP-9 (verschiedene Alkylphenylethylenglykole) (beide von Union Carbide Corporation) sowie Nonylphenylethoxylat mit dem Markennamen Triton N-57® (Hersteller: Rohm & Haas) genannt. (siehe II.1 bis II.2) Experimentell konnte belegt werden, dass Toluolsulfonsäure selbst in höherer Konzentration (über 3 % bezogen auf das gesamte Texturmittel) in Texturmitteln mit etwas erhöhtem Alkalihydroxidgehalt, z.B. zwischen 5 bis 10 Gew.-%, einen starken Textureffekt zeigt, der in Systemen mit niedrigen Gehalten an Alkalihydroxid und Toluolsulfonsäure nicht beobachtet wird.

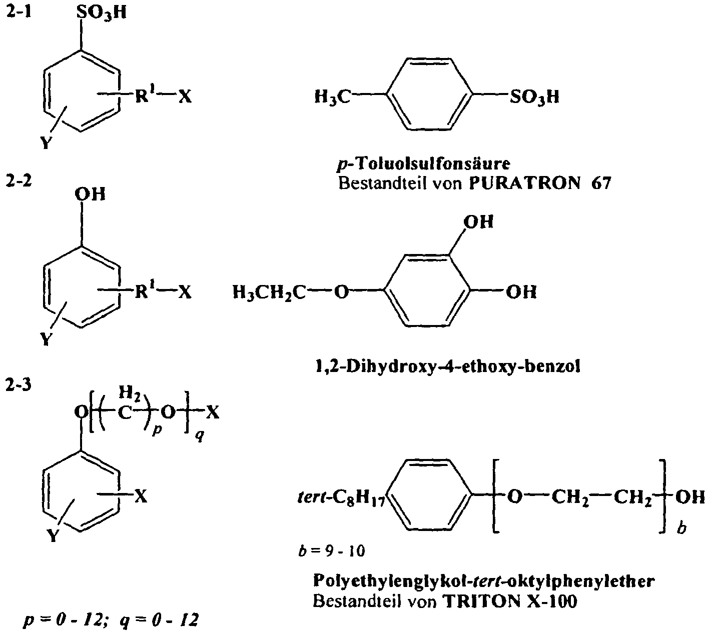

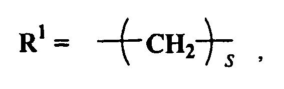

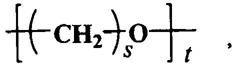

**-H**

*s=0-12; t* = *0 - 12*

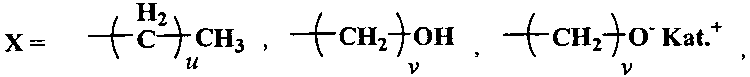

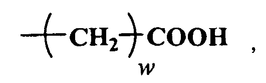

**-SO₃H,**

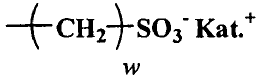

*u = 0 -16; v = 1 - 16; w = 0 - 2*

**Y = -H, -OH, -SH, -COOH, -SO₃H -NH₂, -NH(Alkyl), -N(Alkyl)₂**

### II.2: Substituierte aromatische Sulfonsäuren, Alkohole und Ether mit jeweils einem bevorzugten Vertreter

Die Behandlungslösung enthält dabei vorzugsweise 0,1 bis 10 Gew.-% der Sulfonsäure.

Eine weitere bevorzugte Variante sieht vor, dass als schwerflüchtige organische Verbindungen solche aus der Gruppe der Schwefelsäurealkylester sowie deren Salze eingesetzt werden. Besonders bevorzugt sind hier Laurylsulfate, Myristylsulfate, Stearylsulfate, Caprylsulfate, z.B. Natriumlaurylsulfat, Kaliumlaurylsulfat, Ammoniumlaurylsulfat, Ammoniumcaprylsulfat (vgl.: III).

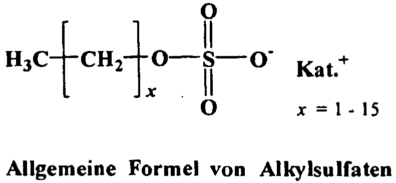

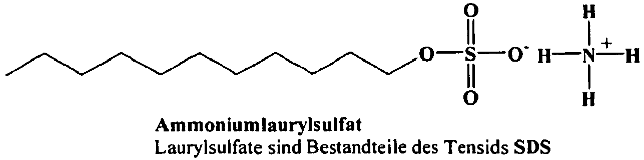

### III: Alkylsulfate mit Ammoniumlaurylsulfat als einem bevorzugten Vertreter

In einer weiteren bevorzugten Ausführungsform werden als schwerflüchtige organische Verbindungen Polysorbate eingesetzt (vgl.: IV). Ein besonders bevorzugter Vertreter dieser Stoffgruppe ist Polyoxyethylensorbitan-monolaurat, unter dem Markennamen TWEEN® 20 (Uniqema, ICI Americas. Inc.) in hoher Reinheit kommerziell erhältlich.

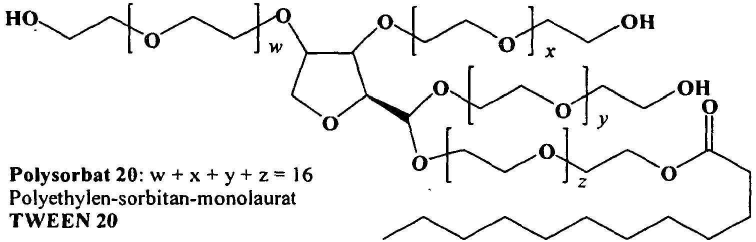

### IV: Polysorbate mit Polysorbat 20 (TWEEN® 20) als bevorzugtem Vertreter

Als Ätzmittel enthält das erfindungsgemäße Texturmittel eine Verbindung ausgewählt aus der Gruppe bestehend aus Natriumhydroxid, Kaliumhydroxid, , Ethylendiamin-Pyrokatechol und Mischungen hiervon.

Vorzugsweise ist das Ätzmittel, der Hydroxid-Ionen-Lieferant, in einer Konzentration von 4 bis 15 Gew.-%, bezogen auf das gesamte Texturmedium, insbesondere 5 bis 7 Gew.-% enthalten.

Zusätzlich kann das Texturmedium mindestens eine leichtflüchtige organische Komponente, insbesondere einen leichtflüchtigen, linearen oder verzweigten Alkohol mit einer Siedetemperatur von maximal 120°C enthalten. Der leichtflüchtige Alkohol ist vorzugsweise ausgewählt aus der Gruppe bestehend aus Methanol, Ethanol, n-Propanol, iso-Propanol, n-Butanol, sec-Butanol, iso-Butanol, tert-Butanol und Mischungen hiervon. Der leichtflüchtige Alkohol liegt bevorzugt in einer Konzentration von 2 bis 20 Gew.-%, insbesondere 2 bis 10 Gew.-%, bezogen auf das gesamte Texturmedium, vor.

Weiterhin kann die Behandlungslösung vorzugsweise ein weiteres Tensid enthalten. Dieses wird erfindungsgemäß eingesetzt, um eine weitere, diesmal großflächige Homogenisierung des chemischen Angriffs der Waferoberfläche und dadurch eine Verbesserung der optischen Qualität des Wafers zu erreichen. Diese optische Homogenität ist im Hinblick auf die Ästhetik der Wafer von besonderer Bedeutung, die in der kommerziellen Solarzellenproduktion ein entscheidender Preisfaktor für Industriesolarzellen ist.

Das Tensid ist vorzugsweise ausgewählt aus der Gruppe bestehend aus Natriumlaurylsulfat, Polyethylenglykol, Polyethylenglycol-Octylphenylether und Mischungen hiervon. Dabei kann das Tensid in einer Konzentration von 1 bis 20 Gew.-%, insbesondere 2 bis 10 Gew.-%, bezogen auf die gesamte Behandlungslösung, enthalten sein.

Vorzugsweise ist das Texturmedium in Tauchätzverfahren einsetzbar, die als Durchlauf- oder Batch-Verfahren ausführbar sind.

Das Texturmedium weist vorzugsweise eine Viskosität im Bereich von 0,3 bis 1000 mPa·s, bevorzugt von 0,5 bis 100 mPa·s und besonders bevorzugt von 0,6 bis 10 mPa·s auf.

Anhand des nachfolgenden Beispiels soll das erfindungsgemäße Verfahren näher erläutert werden, ohne dieses auf die hier gezeigten speziellen Ausführungsformen einschränken zu wollen.

### Beispiel 1

### Reinigung, Schadensätze und Texturierung in einem Schritt beim Batch-Prozess

Ein erfindungsgemäßes Beispiel zur Reinigung, Schadensätze und Texturierung in einem Ätzschritt betrifft einen Batch-Reinigungsprozess, bei dem eine Anlage aus vier Modulen besteht, die räumlich über jeweils eine Luftschleuse voneinander getrennt sind. Jedes Modul besteht aus einer nach außen abgeschlossenen Kammer variierbarer Länge, je nach Anzahl gleichzeitig zu prozessierender Wafer. Die Kammern werden nur kurzzeitig zum Be- und Entladen, welches max. 10 Sekunden pro Modul in Anspruch nimmt, geöffnet und verfügen über einen minimalen Gasraum, damit die thermische und chemische Gleichgewichtseinstellung zwischen flüssiger Phase und Gasphase schnell erfolgen kann.

In den einzelnen Kammern befinden sich Prozesswannen, in welche Schienen eingetaucht werden können, auf denen die Wafer zu Beginn des Reinigungsprozesses fixiert werden und auf denen sie von Prozesskammer zu Prozesskammer wechseln.

In den einzelnen Modulen laufen folgende Teilprozesse ab:

### Modul 1: Vorreinigen der mit Slurry verschmutzten Wafer mit Hilfe von DI-Wasser

Im Modul befindet sich eine Wanne, die nach jedem Spülschritt entleert wird. Reinigungsmedium ist 40 - 80°C warmes DI-Wasser. Die Wafer werden optional während der Spülung mit einer Megaschallquelle beschallt. Beschallungsfrequenz ist 1 MHz. Die Prozessdauer beträgt vorzugsweise 6 ½ min.

### Modul 2: Schadensätze verbunden mit Abtrag der Kontaminationen, welche sich in der geschädigten Schicht befinden + Textur der Waferoberfläche

In Modul 2 befindet sich analog zu Modul 1 mindestens ein Basin, in dem die zu prozessierenden Wafer waagerecht fixiert sind.

Ein bevorzugtes Ausführungsbeispiel besitzt als Ätzmedium in Modul 2 eine 5 gewichtsprozentige KOH-Lösung mit 7 Gew.-% Toluolsulfonsäure bezogen auf die gesamte Lösung. Die Ätzzeit beträgt 20 min; die Badtemperatur liegt bei 110°C. Die Fließgeschwindigkeit des Ätzmediums beträgt auf der Waferoberfläche ca. 5 cm/min bei einer Filmdicke von 3 mm.

Im Gegensatz zu den anderen Modulen, in denen die Verweilzeit ca. 6,5 Min. beträgt, ist die Verweilzeit der Wafer in Modul 2 etwa 3 mal höher. Um einen kontinuierlichen Prozessfluss zu garantieren, werden in Modul 2 mindestens drei Waferschienen (Carrier) gleichzeitig prozessiert, die zeitlich versetzt in einem Abstand von ca. 6 bis 6,5 Min. in die Kammer eingebracht bzw. aus dieser entfernt werden.

Ein weiteres Ausführungsbeispiel sieht als Ätzmedium für Modul 2 eine wässrige Natriumhydroxidlösung mit Adipinsäure als Texturtensid vor, wobei der NaOH-Gehalt der Lösung bei 6 Gew.-% und der Adipinsäuregehalt bei 4 Gew.-% bezogen auf die gesamte Lösung liegen. Die Ätzzeit beträgt auch hier 20 min; die Badtemperatur liegt bei 110°C. Die Fließgeschwindigkeit des Ätzmediums beträgt auf der Waferoberfläche ca. 4 cm/min bei einer Filmdicke von 4 mm.

### Modul 3: Nachspülen der fertig texturierten Wafer mit DI-Wasser

Aufgabe dieses Prozessschrittes ist die Entfernung verbliebener Ätzlösungsreste auf den Wafern aus Modul 2.

Eine bevorzugte Ausführung der Erfindung sieht die gleiche bauliche Ausführung des Moduls 3 vor wie sie bei Modul 1 vorhanden ist. Dabei sind ebenso die Prozessparameter (Prozesszeit, Prozesstemperatur, Beschallung der Becken) jenen aus Modul 1 identisch.

Bei einer weiteren bevorzugten Ausführung der Erfindung werden die Wafer mittels einer Spray-Vorrichtung von den Ätzlösungsresten gereinigt. Die Prozessdauer beträgt dann jedoch nur 3 - 3 ½ min.

### Modul 4: Verkürzte RCA-Reinigung

Aufgabe dieses Reinigungsschrittes ist die Entfernung noch verschleppter Reste metallischer und organischer Kontaminationen auf der Waferoberfläche.

Bei einer bevorzugten Ausführungsform der Erfindung umfasst Modul 4 zwei Wannen. Die erste Wanne ist mit einer wässrigen Ammoniumhydroxid (NH₄OH)/Wasserstoffperoxid (H₂O₂)-Lösung in den für RCA-Reinigungen üblichen Konzentrationen bestückt. Die Prozesstemperatur beträgt hier bevorzugt 80 - 90°C, die Prozesszeit 6 ½ bis 7 min.

Bei einer weiteren bevorzugten Ausführungsform ist die erste Wanne von Modul 4 mit einer halbkonzentrierten HCl-Lösung befüllt. Die Prozesszeit für den darin durchgeführten HCl-Dip beträgt ca. 2 min, die Prozesstemperatur 50°C.

Die zweite Wanne enthält wässrige, verdünnte bis halbkonzentrierte HF-Lösung. Prozesstemperatur ist 25°C (Raumtemperatur), Prozessdauer 10 - 15 Sekunden. Nach Verlassen der Wanne werden die Wafer einem 3 - 3½ min. andauernden Spray-Durchgang mit DI-Wasser in Modul 3 unterzogen.

In diesem Zustand können sie sofort ohne weitere Aufreinigungsschritte weiterprozessiert werden.

Mit dem vorliegenden Verfahren behandelte Wafer wiesen im praktischen Versuch tendenziell bessere optische Eigenschaften (verringerte Reflexion) und vergleichbare elektrische (Oberflächenladungsträgerrekombinationsgeschwindigkeit) und signifikant bessere mechanische Eigenschaften (höhere Bruchfestigkeit) auf, wie mit dem klassischen Reinigungs- und Texturkonzept bearbeitete Wafer.

### Beispiel 2

### Reinigung und Textur drahtgesägter Wafer

Ein weiteres erfindungsgemäßes Beispiel zur Texturierung von drahtgesägten Wafern bei gleichzeitiger Reinigung betrifft einen Batch-Prozess, bei dem in Modul 2 ein Ätzmedium zum Einsatz kommt, das, bezogen auf die gesamte Lösung, zu 3,5 Gew-% Kaliumtosylat (Kaliumsalz der p-Toluolsulfonsäure), 1 Gew.-% Kaliumtatrat (Kaliumsalz der Weinsäure), 4 Gew.-% Kaliumhydroxid und 2 Gew.-% 2-Propanol besteht. Die Prozesszeit beträgt in Modul 2 21 bis 25 Minuten bei ca. 80 bis 85 °C Badtemperatur.

### Beispiel 3

### Reinigung und Textur drahtgesägter Wafer

Ein weiteres erfindungsgemäßes Beispiel zur Reinigung und Texturierung von drahtgesägten Wafern betrifft einen Batch-Prozess, bei dem in Modul 2 ein Ätzmedium zum Einsatz kommt, das bezogen auf die gesamte Lösung, zu 3,5 Gew.-% Kaliumtosylat, 1 Gew.-% Ammoniumcitrat, 5 Gew.-% Kaliumhydroxid, 3,5 Gew.-% 2-Propanol und 0,5 Gew.-% Triton® X-100 besteht. Die Prozesszeit beträgt in Modul 2 21 bis 25 Minuten bei einer Badtemperatur von 82 bis 85 °C.

In Modul 4 ist die erste Wanne mit 5 Gew.-% HCl-Lösung bestückt. Badtemperatur ist 35 °C. Die Eintauchzeit beträgt 2 Minuten.

Die restlichen Versuchsparameter sind analog jenen in Ausführungsbeispiel 1.

### Beispiel 4

### Reinigung und Textur drahtgesägter Wafer

Ein weiteres erfindungsgemäßes Beispiel zur Reinigung und Texturierung von drahtgesägten Wafern betrifft einen Batch-Prozess, bei dem in Modul 2 eine Ätz-/ Reinigungslösung zum Einsatz kommt, welche, bezogen auf Masse der gesamten Lösung, aus 4 Gew.-% Kaliumhydroxid, 3,5 Gew.-% Kaliumtosylat, 2,5 Gew.-% 2-Propanol, 0,5 Gew.-% Natriumlaurylsulfat, und 0,25 Gew.-% EDTA (Ethylendiamintetraacetat) besteht.

In Modul 4 ist die erste Wanne mit 5 Gew.-% HCl-Lösung bestückt. Badtemperatur ist 35°C. Die Eintauchzeit beträgt 2 Minuten.

Die restlichen Versuchsparameter sind analog jenen in Ausführungsbeispiel 1.

Die restlichen Prozessparameter für die anderen Module entsprechen jenen von Ausführungsbeispiel 1.

### Beispiel 5

### Reinigung und Textur drahtgesägter Wafer

Ein weiteres bevorzugtes Beispiel zur Texturierung von drahtgesägten Wafern bei gleichzeitiger Reinigung betrifft einen Batch-Prozess, bei dem in Modul 2 ein Ätzmedium zum Einsatz kommt, das, bezogen auf die gesamte Lösung,1 Gew.-% Brenzcatechin, 4 Gew-% Kaliumtosylat, 5 Gew.-% Kaliumhydroxid besteht. Die Prozesszeit beträgt in Modul 2 21 bis 25 Minuten bei ca. 100 bis 110°C Badtemperatur (schwankend).

### Beispiel 6

### Textur polierter Wafer

Eine erfindungsgemäßes Beispiel zur Texturierung polierter Wafer betrifft einen Batch-Prozess, bei dem das zur Prozessierung erforderliche System aus vier Becken besteht.

In Becken 1 werden die polierten (bereits sehr sauberen) Wafer in reinen Alkohol, vorzugsweise Isopropanol, getaucht. Die Temperatur des Alkohols beträgt zwischen 20 und 25°C. Dieser Schritt dient ausschließlich der gleichmäßigen Benetzung der Oberfläche noch vor dem ersten chemischen Angriff durch die Ätzlösung in Becken 2. Die Wafer wechseln von Bad 1 in Bad 2 im triefenden Zustand.

Becken 2 enthält die eigentliche Texturlösung bestehend aus 5 Gew.-% KOH, 3,5 Gew.-% p-Toluolsulfonsäure und 3,5 Gew.-% 2-Propanol bezogen auf die gesamte Lösung. Die Badtemperatur schwankt während des Ätzprozesses zwischen 80 und 85°C. Die Ätzzeit beträgt zwischen 40 und 50 Minuten, je nach Beckentemperatur (bei Ätztemperaturen um konstant 85°C beträgt sie ca. 40 min).

Becken 3 enthält eine ca. 5 bis 6 Gew.-%-ige Salzsäurelösung mit einer Temperatur von ca. 20 bis 25°C. Nach Verlassen von Becken 2 werden die Wafer kurz mit deionisiertem Wasser abgesprüht, bevor sie in Bad 3 wechseln, wo sie ca. 1 bis 2 Minuten verbleiben.

Prozessschritt 3 in Becken 3 dient der Neutralisation noch verbliebener KOH-Reste auf der Waferoberfläche und somit dem Ätzstopp.
Nach Verlassen von Becken 3 wechseln die Wafer in ein viertes Becken mit reinem, deionisiertem Wasser, wo sie bis auf den Leitwert des deionisierten Wassers gespült werden.

Eine auf diese Weise texturierte Waferoberfläche erreichte im praktischen Experiment einen Reflexionsgrad von ca. 10,8 % (gewichtete Reflexion).

### Beispiel 7

### Textur polierter Wafer

Ein weiteres erfindungsgemäßes Beispiel zur Texturierung polierter Wafer sieht bei sonst gleichen Parametern wie im vorhergehenden Beispiel als Ätzrezeptur für Becken 2 eine wässrige Lösung mit 5 Gew.-% Kaliumhydroxid und 7 Gew.-% Kaliumtosylat (Kaliumsalz der Toluolsulfonsäure) vor. Die Badtemperatur beträgt hier ca. 95 bis 100°C, die Ätzzeit 30 bis 40 Minuten.

### Beispiel 8

### Textur polierter Wafer

Ein weiteres erfindungsgemäßes Beispiel zur Texturierung polierter Wafer sieht als Ätzrezeptur für Becken 2 eine wässrige Lösung von, bezogen auf die gesamte Lösung, 5 Gew-% KOH und 2 Gew.-% Adipinsäurediethylester vor. Die Badtemperatur beträgt ca. 80 °C, die Ätzzeit maximal 50 Minuten. Die Versuchsparameter für die Bäder 1, 3 und 4 sind analog jenen aus Beispiel 1.

Die in Beispiel 2 und 3 dargestellten Rezepturen und Reaktionsbedingungen für Becken 2 sind auch als Ätzmedien für Modul 2 bei einem Reinigungs-/TexturProzess für drahtgesägte, mit Schleifmittel kontaminierte Wafer geeignet.

### Beispiel 9

### Textur polierter Wafer

In einem weiteren erfindungsgemäßen Beispiel wird ganz auf den Einsatz von 2-Propanol im Texturprozess verzichtet. Bad 1 enthält hier an Stelle reinen 2-Propanols eine ca. 40°C warme p-Toluolsulfonsäure-Lösung mit 20 bis 30 Gew.-% Toluolsulfonsäure.

Eine auf diese Weise texturierte Waferoberfläche erreichte im praktischen Experiment einen Reflexionsgrad von ca. 11,3 % (gewichtete Reflexion).

## Patentansprüche

1. Flüssiges Textur- und Reinigungsmedium für die Oberflächenbehandlung von monokristallinen Wafern enthaltend mindestens ein alkalisches Ätzmittel für monokristallines Silizium und mindestens eine schwerflüchtige organische Verbindung mit einer Siedetemperatur von mehr als 110°C, **dadurch gekennzeichnet, dass** die schwerflüchtige organische Verbindung ein Polysorbat, Polyethylen-sorbitan-monolaurat oder ein (Poly)alkohol ausgewählt aus der Gruppe der geradkettigen, verzweigten oder cyclischen C₄-C₈-Diole, geradkettigen, verzweigten oder cyclischen C₆-C₁₂-Triole und Mischungen hiervon, insbesondere ausgewählt aus der Gruppe bestehend aus 1,5-Pentadiol, 1,6-Hexandiol, cis/trans-1,X-Cyclopentandiol (X=2,3), cis/trans-1,X-Cyclohexandiol (X=2,3,4), cis/trans-1,X-Cycloheptandiol (X=2,3,4), Cyclohexantriole, Cycloheptantriole, Cyclononantriole, insbesondere 1,4,7-Cyclononantriol, cis/trans-1,4-Cyclohexandiol und Mischungen hiervon oder die organische Verbindung mindestens eine gegebenenfalls substituierte aromatische Sulfonsäure oder ein gegebenenfalls substituierter aromatischer Di-Alkohol oder Toluolsulfonsäure oder ein gegebenenfalls alkylsubstituiertes Dihydroxybenzol oder 1,3-Dihydroxy-4-Methylbenzol oder 1,2-Dihydroxy-4-Methylbenzol ist und **dadurch gekennzeichnet, dass** das Ätzmittel ausgewählt ist aus der Gruppe bestehend aus Natriumhydroxid, Kaliumhydroxid, Ethylendiamin-Pyrokatechol und Mischungen hiervon.

2. Textur- und Reinigungsmedium nach Anspruch 1,
**dadurch gekennzeichnet, dass** die schwerflüchtige organische Verbindung eine Siedetemperatur von mindestens 120°C, insbesondere mindestens 150 °C aufweist.

3. Textur- und Reinigungsmedium nach einem der vorhergehenden Ansprüche,
**dadurch gekennzeichnet, dass** die organische Verbindung in einer Konzentration von, bezogen auf das gesamte Textur- und Reinigungsmedium, 1 bis 20 Gew.-%, insbesondere 2 bis 10 Gew.-% enthalten ist.

4. Textur- und Reinigungsmedium nach einem der vorhergehenden Ansprüche,
**dadurch gekennzeichnet, dass** die Sulfonsäure oder der aromatische Di-Alkohol in einer Konzentration von, bezogen auf die gesamte Behandlungslösung, 0,1 bis 10 Gew.-% enthalten ist.

5. Textur- und Reinigungsmedium nach einem der vorhergehenden Ansprüche,
**dadurch gekennzeichnet, dass** das Ätzmittel in einer Konzentration von, bezogen auf das gesamte Textur- und Reinigungsmedium, 4 bis 15 Gew.-%, insbesondere 5 bis 7 Gew.-% enthalten ist.

6. Textur- und Reinigungsmedium nach einem der vorhergehenden Ansprüche,
**dadurch gekennzeichnet, dass** zusätzlich mindestens ein leichtflüchtiger, linearer oder verzweigter Alkohol mit einer Siedetemperatur von maximal 120 °C, insbesondere ausgewählt aus der Gruppe bestehend aus Methanol, Ethanol, n-Propanol, iso-Propanol, n-Butanol, sec-Butanol, iso-Butanol, tert-Butanol und Mischungen hiervon, enthalten ist.

7. Textur- und Reinigungsmedium nach Anspruch 6,
**dadurch gekennzeichnet, dass** der leichtflüchtige Alkohol in einer Konzentration von, bezogen auf das gesamte Textur- und Reinigungsmedium, 2 bis 20 Gew.-%, insbesondere 2 bis 10 Gew.-% enthalten ist.

8. Textur- und Reinigungsmedium nach einem der vorhergehenden Ansprüche,
**dadurch gekennzeichnet, dass** zusätzlich mindestens ein Tensid, insbesondere ausgewählt aus der Gruppe bestehend aus Natriumlaurylsulfat, Polyethylenglykol, Polyethylenglykol-Octylphenylether und Mischungen hiervon, enthalten ist.

9. Textur- und Reinigungsmedium nach Anspruch 8,
**dadurch gekennzeichnet, dass** das Tensid in einer Konzentration von, bezogen auf das gesamte Textur- und Reinigungsmedium, 1 bis 20 Gew.-%, insbesondere 2 bis 10 Gew.-% enthalten ist.

10. Textur- und Reinigungsmedium nach einem der vorhergehenden Ansprüche,
**dadurch gekennzeichnet, dass** die Oberflächenbehandlung eine simultane Schadensätze, Reinigung und Texturierung der Waferoberfläche umfasst.

11. Textur- und Reinigungsmedium nach einem der vorhergehenden Ansprüche,
**dadurch gekennzeichnet, dass** das Medium in Tauchätzverfahren, insbesondere in Durchlauf- oder Batch-Verfahren einsetzbar ist.

12. Textur- und Reinigungsmedium nach einem der vorhergehenden Ansprüche,
**dadurch gekennzeichnet, dass** das Medium eine Viskosität im Bereich von 0,3 bis 1000 mPa·s, bevorzugt von 0,5 bis 100 mPa·s und besonders bevorzugt von 0,6 bis 10 mPa·s aufweist.

13. Verwendung des Textur- und Reinigungsmediums nach einem der vorhergehenden Ansprüche zur Texturierung der Oberflächen von monokristallinen Wafern, insbesondere polierten Wafern, zur simultanen Schadensätze, Reinigung und Texturierung der Oberflächen von monokristallinen Wafern oder zur Beseitigung der beim Drahtsägen von Wafern auftretenden Kontaminationen.

## Claims

1. A liquid texturing and cleaning medium for the surface treatment of monocrystalline wafers, containing at least one alkaline etching agent for monocrystalline silicon and at least one low-volatility organic compound with a boiling temperature of more than 110°C,
**characterised in that** the low-volatility organic compound is a polysorbate, polyethylene sorbitan monolaurate or a (poly)alcohol selected from the group of straight-chain, branched or cyclic C₄-C₈-diols, straight-chain, branched or cyclic C₆-C₁₂-triols and mixtures thereof, in particular selected from the group consisting of 1,5-pentadiol, 1,6-hexanediol, cis/trans-1,X-cyclopentanediol (X=2, 3), cis/trans-1,X-cyclohexanediol (X=2, 3, 4), cis/trans-1,X-cycloheptanediol (X=2, 3, 4), cyclohexanetriols, cycloheptanetriols, cyclononanetriols, in particular 1,4,7-cyclononanetriol, cis/trans-1,4-cyclohexanediol and mixtures thereof, or the organic compound is at least one optionally substituted aromatic sulphonic acid or an optionally substituted aromatic di-alcohol or toluenesulphonic acid or an optionally alkyl-substituted dihydroxybenzene or 1,3-dihydroxy-4-methylbenzene or 1,2-dihydroxy-4-methylbenzene, and **characterised in that** the etching agent is selected from the group consisting of sodium hydroxide, potassium hydroxide, ethylenediamine pyrocatechol and mixtures thereof.

2. A texturing and cleaning medium according to Claim 1, **characterised in that** the low-volatility organic compound has a boiling temperature of at least 120°C, in particular at least 150°C.

3. A texturing and cleaning medium according to one of the preceding claims, **characterised in that** the organic compound is contained in a concentration, relative to the entire texturing and cleaning medium, of 1 to 20% by weight, in particular 2 to 10% by weight.

4. A texturing and cleaning medium according to one of the preceding claims, **characterised in that** the sulphonic acid or the aromatic di-alcohol is contained in a concentration, relative to the entire treatment solution, of 0.1 to 10% by weight.

5. A texturing and cleaning medium according to one of the preceding claims, **characterised in that** the etching agent is contained in a concentration, relative to the entire texturing and cleaning medium, of 4 to 15% by weight, in particular 5 to 7% by weight.

6. A texturing and cleaning medium according to one of the preceding claims, **characterised in that** at least one readily volatile, linear or branched alcohol with a boiling temperature of at most 120°C, in particular selected from the group consisting of methanol, ethanol, n-propanol, iso-propanol, n-butanol, sec-butanol, iso-butanol, tert-butanol and mixtures thereof, is additionally contained.

7. A texturing and cleaning medium according to Claim 6, **characterised in that** the readily volatile alcohol is contained in a concentration, relative to the entire texturing and cleaning medium, of 2 to 20% by weight, in particular 2 to 10 % by weight.

8. A texturing and cleaning medium according to one of the preceding claims, **characterised in that** at least one surfactant, in particular selected from the group consisting of sodium lauryl sulphate, polyethylene glycol, polyethylene glycol octyl phenyl ether and mixtures thereof, is additionally contained.

9. A texturing and cleaning medium according to Claim 8, **characterised in that** the surfactant is contained in a concentration, relative to the entire texturing and cleaning medium, of 1 to 20% by weight, in particular 2 to 10 % by weight.

10. A texturing and cleaning medium according to one of the preceding claims, **characterised in that** the surface treatment comprises simultaneous damage etching, cleaning and texturing of the wafer surface.

11. A texturing and cleaning medium according to one of the preceding claims, **characterised in that** the medium can be used in immersion-etching methods, in particular in continuous or batch methods.

12. A texturing and cleaning medium according to one of the preceding claims, **characterised in that** the medium has a viscosity in the range of 0.3 to 1000 mPa·s, preferably of 0.5 to 100 mPa·s, and particularly preferably of 0.6 to 10 mPa·s.

13. Use of the texturing and cleaning medium according to one of the preceding claims for texturing the surfaces of monocrystalline wafers, in particular polished wafers, for simultaneous damage etching, cleaning and texturing of the surfaces of monocrystalline wafers or for overcoming the contamination occurring when wire-sawing wafers.

## Revendications

1. Agent liquide de texturation et de nettoyage pour le traitement de surfaces de plaquettes monocristallines contenant au moins un agent décapant alcalin pour silicium monocristallin et au moins un composé organique peu volatil d'une température d'ébullition supérieure à 110°C, **caractérisé en ce que** le composé organique très peu volatil est un polysorbate, un monolaurate de polyéthylène-sorbitane ou un (poly)alcool choisi dans le groupe des diols en C₄-C₈ linéaires, ramifiés ou cycliques, des triols en C₆-C₁₂ linéaires, ramifiés ou cycliques et de leurs mélanges, notamment choisi dans le groupe constitué par le 1,5-pentanediol, le 1,6-hexanediol, le cis/trans-1,X-cyclopentanediol (X = 2, 3), le cis/trans-1,X-cyclohexanediol (X = 2, 3, 4), le cis/trans-1,X-cycloheptanediol (X = 2, 3, 4), les cyclohexanetriols, les cycloheptanetriols, les cyclononanetriols, notamment le 1,4,7-cyclononanetriol, le cis/trans-1,4-cyclohexanediol et leurs mélanges, ou le composé organique est au moins un acide sulfonique aromatique éventuellement substitué ou un dialcool aromatique éventuellement substitué ou l'acide toluènesulfonique ou un dihydroxybenzène éventuellement à substitution alkyle ou le 1,3-dihydroxy-4-méthylbenzène ou le 1,2-dihydroxy-4-méthylbenzène, et **caractérisé en ce que** l'agent décapant est choisi dans le groupe constitué par l'hydroxyde de sodium, l'hydroxyde de potassium, l'éthylènediamine-pyrocatéchol et leurs mélanges.

2. Agent de texturation et de nettoyage selon la revendication 1, **caractérisé en ce que** le composé organique peu volatil présente une température d'ébullition d'au moins 120 °C, notamment d'au moins 150 °C.

3. Agent de texturation et de nettoyage selon l'une quelconque des revendications précédentes, **caractérisé en ce que** le composé organique est contenu en une concentration de 1 à 20 % en poids, notamment de 2 à 10 % en poids, par rapport à l'ensemble de l'agent de texturation et de nettoyage.

4. Agent de texturation et de nettoyage selon l'une quelconque des revendications précédentes, **caractérisé en ce que** l'acide sulfonique ou le dialcool aromatique est contenu en une concentration de 0,1 à 10 % en poids par rapport à l'ensemble de la solution de traitement.

5. Agent de texturation et de nettoyage selon l'une quelconque des revendications précédentes, **caractérisé en ce que** l'agent décapant est contenu en une concentration de 4 à 15 % en poids, notamment de 5 à 7 % en poids, par rapport à l'ensemble de l'agent de texturation et de nettoyage.

6. Agent de texturation et de nettoyage selon l'une quelconque des revendications précédentes, **caractérisé en ce qu'**est en outre contenu au moins un alcool linéaire ou ramifié volatil avec une température d'ébullition d'au plus 120 °C, notamment choisi dans le groupe constitué par le méthanol, l'éthanol, le n-propanol, l'isopropanol, le n-butanol, le sec-butanol, l'isobutanol, le tert-butanol et leurs mélanges.

7. Agent de texturation et de nettoyage selon la revendication 6, **caractérisé en ce que** l'alcool volatil est contenu en une concentration de 2 à 20 % en poids, notamment de 2 à 10 % en poids, par rapport à l'ensemble de l'agent de texturation et de nettoyage.

8. Agent de texturation et de nettoyage selon l'une quelconque des revendications précédentes, **caractérisé en ce qu'**est en outre contenu au moins un tensioactif, notamment choisi dans le groupe constitué par le laurylsulfate de sodium, le polyéthylène glycol, l'éther octylphénylique de polyéthylèneglycol et leurs mélanges, est également contenu.

9. Agent de texturation et de nettoyage selon la revendication 8, **caractérisé en ce que** le tensioactif est contenu en une concentration de 1 à 20 % en poids, notamment de 2 à 10 % en poids, par rapport à l'ensemble de l'agent de texturation et de nettoyage.

10. Agent de texturation et de nettoyage selon l'une quelconque des revendications précédentes, **caractérisé en ce que** le traitement de surfaces comprend un décapage des défauts, un nettoyage et une texturation simultanés de la surface des plaquettes.

11. Agent de texturation et de nettoyage selon l'une quelconque des revendications précédentes, **caractérisé en ce que** l'agent peut être utilisé dans des procédés de décapage par immersion, notamment dans des procédés continus ou discontinus.

12. Agent de texturation et de nettoyage selon l'une quelconque des revendications précédentes, **caractérisé en ce que** l'agent présente une viscosité dans la plage de 0,3 à 1 000 mPa·s, de préférence de 0,5 à 100 mPa·s et de manière particulièrement préférée de 0,6 à 10 mPa·s.

13. Utilisation de l'agent de texturation et de nettoyage selon l'une quelconque des revendications précédentes pour la texturation des surfaces de plaquettes monocristallines, notamment de plaquettes polies, pour un décapage des défauts, un nettoyage et une texturation simultanés des surfaces de plaquettes monocristallines ou pour la suppression des contaminations se produisant lors du sciage à fil de plaquettes.
